# EUROPÄISCHE PATENTSCHRIFT

(11) **EP 1 179 748 B1**
(45) Veröffentlichungstag und Bekanntmachung des Hinweises auf die Patenterteilung: **15.12.2004**
(21) Anmeldenummer: 01118529.5
(22) Anmeldetag: 01.08.2001
(51) Int. Cl.: G03F 1/00, G12B 21/08, G01N 21/956

(54) **Kombination von abtastenden und abbildenden Methoden bei der Überprüfung von Photomasken**
Combination of imaging and scanning methods for checking reticles
Méthodes combinant le balayage et la visualisation pour une vérification de masque lithographiques

(30) Priorität: 04.08.2000 DE 10039337
(43) Veröffentlichungstag der Anmeldung: 13.02.2002
(73) Patentinhaber: Infineon Technologies AG, 81669 München (DE)
(72) Erfinder: Rotsch, Christian, 80687 München (DE)
(74) Vertreter: Graf Lambsdorff, Matthias, Dr.

(56) Entgegenhaltungen:
- DE-A- 19 819 492
- US-A- 5 634 230
- US-A- 6 085 581
- PATENT ABSTRACTS OF JAPAN vol. 018, no. 339 (P-1760), 27. Juni 1994 (1994-06-27) & JP 06 083037 A (TOSHIBA CORP), 25. März 1994 (1994-03-25) & JP 06 083037 A (TOSHIBA CORP) 25. März 1994 (1994-03-25)

## Beschreibung

Die Erfindung betrifft eine Vorrichtung sowie ein Verfahren zum Abbilden und Abtasten von Masken für die Halbleiterfertigung.

Derartige Photomasken werden für die Belichtungsschritte bei der Halbleiterfertigung benötigt. Um beispielsweise in einem CMOS-Prozeß Strukturgrößen von 180 nm realisieren zu können, werden Photomasken mit Strukturgrößen von ca. 700 nm (also etwa dem Vierfachen der zu erzeugenden Strukturgröße) benötigt. Die Belichtung des mit photosensitivem Lack beschichteten Halbleitersubstrats erfolgt dann über derartige Photomasken. An den Belichtungsschritt schließen sich dann typischerweise Ätz- und Bedampfungsschritte an.

Zur Qualitätskontrolle bei der Herstellung derartiger Photomasken bietet sich wegen der typischen Strukturgröße von 700 nm die optische Mikroskopie an. Eine Photomaske besteht aus einem Glassubstrat, auf das die gewünschte Struktur durch Aufdampfen von Molybdänsilizium (MoSi) bzw. Chrom aufgebracht wird. Die lichtdurchlässigen und lichtundurchlässigen Bereiche der Photomaske lassen sich mit optischen Mikroskopieverfahren in gutem Kontrast darstellen.

Neben der optischen Mikroskopie gewinnen abtastende Verfahren wie die Rastersondenmikroskopie bei der Analyse von Photomasken an Bedeutung. Bei derartigen Verfahren wird das Höhenprofil der Maskenoberfläche mittels einer Sonde abgetastet. Piezokeramische Stellglieder erlauben eine hochgenaue Positionierung der Sonde relativ zur Maskenoberfläche, so daß das Höhenrelief auf der Schichtseite der Maske mit hoher Auflösung erfaßt werden kann. Bei der Verwendung der Rastersondenmikroskopie stellt sich das Problem, die Abtastsonde zu Beginn des Abtastvorgangs an der richtigen Stelle der Maskenoberfläche zu plazieren. Bei manueller Positionierung der Sonde auf der Maske ist häufig nicht klar, welcher Bereich der Oberfläche gerade abgetastet wird. Es wäre daher hilfreich, die Sonde unter Sicht auf der Maske positionieren zu können.

Es ist bekannt, ein Rastersondenmikroskop bzw. ein Oberflächenprofilometer mit einer abbildenden Optik sowie einer Miniaturkamera auszurüsten, um auf diese Weise die Position der Sonde auf der Maskenoberfläche verfolgen zu können. Nachteilig an dieser Lösung ist zum einen das geringe Gesichtsfeld der Kamera. Zum zweiten müssen bei einer derartigen Ausführungsform des Rastersondenmikroskops bzw. des Oberflächenprofilometers sehr viele Funktionen auf engstem Raum integriert werden, was die Handhabung des abtastenden Instruments erschwert. Die Durchführung von Justierarbeiten sowie der Ersatz beschädigter Abtastsonden gestaltet sich schwierig.

Aufgabe der Erfindung ist es daher, eine Vorrichtung sowie ein Verfahren zur Verfügung zu stellen, welche die Abtastung und Abbildung von definierten Bereichen der Maskenoberfläche erleichtern.

Diese Aufgabe wird durch eine Vorrichtung zum Abbilden und Abtasten von Masken für die Halbleiterfertigung gemäß Anspruch 1 sowie durch ein Verfahren gemäß Anspruch 18 gelöst.

Bei der erfindungsgemäßen Vorrichtung erfolgt die Abtastung der Maske von der Schichtseite her, während das optische Mikroskop die Maskenstrukturen von der der Schichtseite abgewandten Maskenseite her abbildet. Durch Verwendung eines derartigen invertierten Mikroskops kann gleichzeitig die Oberseite der Maske abgetastet werden, während die optische Abbildung von der Unterseite der Maske aus erfolgt. Auf diese Weise wird vermieden, daß sich das abtastende Instrument und das optische Mikroskop gegenseitig behindern. Beide Instrumente können relativ zur Maske und relativ zum jeweils anderen Instrument frei positioniert werden.

Weiterhin weist die erfindungsgemäße Erfindung Mittel zur Positionierung des abtastenden Instruments und des gegenüberliegenden optischen Mikroskops auf, mit denen die beiden Instrumente relativ zueinander so positioniert werden können, daß die Sonde des abtastenden Instruments von dem optischen Mikroskop mit abgebildet werden kann. Sobald die Sonde des abtastenden Instruments im Mikroskopbild erkennbar ist, befinden sich die beiden Instrumente in einander gegenüberliegenden Positionen, die durch eine senkrecht zur Maskenoberfläche verlaufende Achse verbunden sind (sogenannte "onaxis"-Position). In dieser Position wird das abtastende Instrument relativ zum optischen Mikroskop fixiert.

Die Positionierung der Sonde auf der Maske erfolgt bei der erfindungsgemäßen Lösung durch eine Lateralverschiebung der Maske relativ zu den beiden gegeneinander fixierten Instrumenten. Zu diesem Zweck umfaßt die erfindungsgemäße Vorrichtung Mittel zum lateralen Verschieben der Maske, durch die der abgebildete Ausschnitt der Maske unter Beibehaltung der Relativposition zwischen dem abtastenden Instrument und dem gegenüberliegenden optischen Mikroskop auswählbar ist. Da die Relativposition zwischen dem abtastenden Instrument und dem gegenüberliegenden Mikroskop einmal in der "on-axis"-Position fixiert wurde, bleibt die Position der Sonde im Gesichtsfeld des optischen Mikroskops unverändert. Die Sonde ist daher ständig in dem vom optischen Mikroskop gelieferten Bild sichtbar, auch wenn die Position der Maskenoberfläche relativ zur Sonde verändert wird.

Sobald die beiden Instrumente einmal in der "on-axis"-Position gegeneinander fixiert sind, können verschiedene Bereiche der Photomaske angefahren und untersucht werden. Die zeitraubende und mühsame Suche der Sonde im Gesichtsfeld des optischen Mikroskops entfällt. Damit wird eine schnelle und präzise Positionierung der Sonde auf der Maskenoberfläche ermöglicht. Verschiedene fertigungskritische Strukturen der Photomaske können nacheinander angefahren und dann jeweils abgebildet und abgetastet werden.

Das erfindungsgemäße Verfahren zum Abbilden und Abtasten von Masken für die Halbleiterfertigung umfaßt drei Schritte. In einem ersten Schritt werden das abtastende Instrument und das optische Mikroskop relativ zueinander positioniert. Die Positionierung erfolgt dergestalt, daß die Sonde des abtastenden Instruments von dem optischen Mikroskop mit abgebildet werden kann. Aus der vom optischen Mikroskop gelieferten Abbildung der Maske ist also die Position der Sonde des abtastenden Instruments erkennbar. Dies zeigt, daß sich das abtastende Instrument und das gegenüberliegende optische Mikroskop in der "on-axis"-Position befinden. Anschließend wird in einem zweiten Schritt die Maske lateral verschoben, wobei die Relativposition zwischen dem abtastenden Instrument und dem gegenüberliegenden optischen Mikroskop beibehalten wird. Die Sonde des abtastenden Instruments kann daher relativ zur Photomaske beliebig positioniert werden. Die Sonde bleibt dabei stets in dem durch das optische Mikroskop gelieferten Bild erkennbar. Wenn der gewünschte Ausschnitt der Maske aufgefunden ist, wird der ausgewählte Maskenbereich in einem dritten Schritt abgebildet und/oder abgetastet.

Der Vorteil dieses Verfahrens ist, daß die mühsame und zeitaufwendige Suche nach der Sonde des abtastenden Instruments nur genau einmal pro untersuchter Maske durchgeführt werden muß.

Gemäß einer vorteilhaften Ausgestaltung der Erfindung umfassen die Mittel zum lateralen Verschieben der Maske einen verschieblich gelagerten Maskentisch. Die Photomaske wird auf dem Maskentisch fixiert und kann dann in zwei Koordinatenrichtungen senkrecht zu der Achse bewegt werden, die durch das abtastende Instrument und das optische Mikroskop festgelegt ist. Mittels eines derartigen Probentisches kann die Photomaske relativ zu den beiden Instrumenten präzise positioniert werden.

Dabei ist es von Vorteil, wenn der Maskentisch mittels Schrittmotoren positionierbar ist. Dadurch ist es möglich, die Verschiebung des Probentisches automatisch zu steuern. Vorgegebene Stellen auf der Maskenoberfläche können so exakt angefahren werden. Schrittmotoren erlauben eine auf Bruchteile von Mikrometern genaue Positionierung.

Gemäß einer weiteren vorteilhaften Ausführungsform der Erfindung sind die Mittel zur Positionierung des abtastenden Instruments und des gegenüberliegenden optischen Mikroskops relativ zueinander mittels einer verschieblichen Lagerung des abtastenden Instruments und/oder des optischen Mikroskops realisiert. Die verschiebliche Lagerung erlaubt ein schnelles Auffinden der Sonde des Abtastinstruments mit dem optischen Mikroskop.

Es ist von Vorteil, wenn es sich bei dem abtastenden Instrument um ein Rastersondenmikroskop handelt. Die Rastersondenmikroskopie ermöglicht eine Abtastung der Maskenoberfläche mit hoher lateraler Auflösung und eignet sich daher insbesondere für die Überprüfung von Maskenstrukturen.

Bei dem Rastersondenmikroskop kann es sich um ein Rasterkraftmikroskop handeln. Im sogenannten Scan-Modus wird die Abtastspitze des Rasterkraftmikroskops in Richtung der Maskenoberfläche abgesenkt. Sobald die Spitze die Maskenoberfläche erreicht hat, beginnt sich der Cantilever zu verbiegen. Aus den Punkten beginnender Verbiegung kann ein exaktes Höhenprofil der Photomaske berechnet werden.

Bei einer alternativen Ausführungsform der Erfindung handelt es sich bei dem abtastenden Instrument um ein Rasterelektronenmikroskop. Bei der Rasterelektronenmikroskopie wird die Oberfläche der Maske mit Elektronen beaufschlagt. Die rückgestreuten Sekundärelektronen werden durch einen piezomechanisch bewegbaren Detektor erfaßt. Aus diesen Sekundärelektronen lassen sich Informationen über die aufgedampften Maskenstrukturen ableiten. Insbesondere die Lage der Kanten der einzelnen Maskenstrukturen läßt sich mit einem Rasterelektronenmikroskop gut erfassen.

Gemäß einer alternativen Ausführungsform der Erfindung handelt es sich bei dem abtastenden Instrument um ein Oberflächenprofilometer. Ein derartiges Profilometer tastet die Maskenoberfläche mittels eines Glasröhrchens von ca. 200 nm Durchmesser ab. Aus den Punkten des Auftreffens des Glasröhrchens auf der Maskenoberfläche läßt sich das Oberflächenprofil der Maske bestimmen. Die Geometrie des Glasröhrchens ist dabei in vorteilhafter Weise an die abzutastende Maskenstruktur (700 nm "main feature size") angepaßt.

Bei einer weiteren vorteilhaften Ausgestaltung der Erfindung erfolgt die für die optische Abbildung erforderliche Beleuchtung der Maske von der der Schichtseite abgewandten Seite her. Die Lichtquelle ist also auf der Seite des optischen Mikroskops, gegenüber des abtastenden Instruments angeordnet. Das von der Mikroskopseite ber einfallende Licht gelangt durch das Glassubstrat der Maske hindurch zu den aufgedampften Oberflächenstrukturen, die das eintreffende Licht zum optischen Mikroskop zurückreflektieren. Die aufgedampften Strukturen erscheinen im Mikroskop daher als Bereiche hoher Lichtintensität. Die lichtdurchlässigen Bereich der Maske dagegen erscheinen dunkel, da das Beleuchtungslicht das Glassubstrat an diesen Stellen ungehindert passieren kann und nicht zum optischen Mikroskop zurückreflektiert wird. Die Beleuchtung der Maske in Auflichtgeometrie hat den Vorteil, daß die Lichtquelle auf der dem abtastenden Instrument gegenüberliegenden Seite angeordnet ist und daher bei der Bedienung dieses Instruments nicht stört. Ein weiterer Vorteil dieser Beleuchtungsanordnung ist, daß die Lichtquelle die Sonde durch die lichtdurchlässigen Bereiche hindurch beleuchtet. Daher ist die hell beleuchtete Sonde gegenüber dem dunklen Hintergrund gut erkennbar.

Gemäß einer alternativen Ausführungsform der Erfindung erfolgt die für die optische Abbildung erforderliche Beleuchtung der Maske von der Schichtseite der Maske her. Die Lichtquelle ist hier auf der Seite des abtastenden Instruments angeordnet. Im Mikroskopbild erscheinen die aufgedampften Strukturen der Maske als dunkle Bereiche. Die lichtdurchlässigen Bereiche der Photomaske erscheinen dagegen hell, weil hier das Beleuchtungslicht ungehindert zum optischen Mikroskop gelangen kann. Der Vorteil einer Beleuchtung in Durchlichtgeometrie ist also, daß die lichtundurchlässigen Bereiche tatsächlich als dunkle Bereiche erscheinen.

Bei Beleuchtung der Maske in Durchlichtgeometrie ist es insbesondere von Vorteil, wenn der Beleuchtungsstrahlengang mindestens einen Spiegel umfaßt. Der Spiegel wird gegenüber des optischen Mikroskops angeordnet und reflektiert das von der Lichtquelle einfallende Licht in Richtung des optischen Mikroskops. Die Lichtquelle kann dabei in einiger Entfernung von den Instrumenten angebracht sein. Auf diese Weise wird verhindert, daß die Lichtquelle bei der Bedienung des abtastenden Instruments stört.

Es ist von Vorteil, wenn das optische Mikroskop ein "Long Working Distance" (LWD) Objektiv aufweist. Derartige Objektive weisen einen großen Abstand zwischen Objektiv und Fokusebene auf. Mit einem derartigen Objektiv läßt sich die Schichtseite der Maske sowie die Sonde des abtastenden Instruments durch das Glassubstrat hindurch scharf abbilden, obwohl das Glassubstrat 2,5 mm bis 6,3 mm dick ist.

Bei einer weiteren vorteilhaften Ausgestaltung der Erfindung ist das optische Mikroskop ein Phasenmikroskop, und als Maske wird eine Phasenmaske verwendet. Anstelle von lichtdurchlässigen und lichtundurchlässigen Bereichen weist eine Phasenmaske Bereiche unterschiedlicher optischer Weglänge auf. Dabei sind sämtliche Bereiche einer (chromlosen) Phasenmaske lichtdurchlässig. Mittels der Phasenkontrastmikroskopie können jedoch Phasenunterschiede des Lichts in Helligkeitsunterschiede umgewandelt werden, und auf diese Weise können die Bereiche unterschiedlicher optischer Weglänge als Bereiche unterschiedlicher Helligkeit sichtbar gemacht werden.

Es ist von Vorteil, wenn das optische Mikroskop mit einer Kamera verbunden ist, welche Daten an eine Bildverarbeitungseinheit liefert. Dadurch wird eine Automatisierung der Qualitätskontrolle von Photomasken ermöglicht. Die Auswertung des optischen Mikroskopbildes muß nicht mehr durch den Menschen erfolgen, sondern kann von einer Bildverarbeitungseinheit durchgeführt werden. Dies ermöglicht eine automatisierte Qualitätssicherung bei der Halbleiterfertigung.

Dabei ist es insbesondere von Vorteil, wenn in der Bildverarbeitungseinheit ein Vergleich des abgebildeten Ausschnitts der Maske mit gespeicherten Maskendaten durchgeführt wird. Dadurch kann zum einen eine Aussage über die Qualität der untersuchten Photomaske gemacht werden. Darüber hinaus ist es möglich, anhand der abgebildeten Maskenstrukturen und der gespeicherten Maskendaten die Position des abgebildeten Ausschnitts relativ zur gesamten Maske zu bestimmen. Auf diese Weise kann ermittelt werden, an welchem Punkt der Maske sich die beiden Instrumente gerade befinden. Auch bei dynamischen Veränderungen der lateralen Position der Maske relativ zu den beiden Instrumenten ist es möglich, jederzeit die aktuelle Beobachtungsposition anzugeben.

Weiterhin ist es von Vorteil, wenn die Bildverarbeitungseinheit Steuersignale zur Positionierung der Maske erzeugt, welche die Mittel zum lateralen Verschieben der Maske steuern. Aus der Analyse des Mikroskopbildes kann die aktuelle Position auf der Maske erhalten werden. Falls diese Position nicht mit der gewünschten Position übereinstimmt, erzeugt die Bildverarbeitungseinheit geeignete Steuersignale zur Ansteuerung des Maskentisches. Der Maskentisch wird neu positioniert, bis die vorgegebene Zielposition erreicht ist. Dadurch können vordefinierte Maskenbereiche völlig automatisch angefahren, abgetastet und abgebildet werden. Dadurch wird eine vollständig automatisierte Maskenkontrolle ermöglicht.

Dabei ist es insbesondere von Vorteil, wenn die Mittel zum lateralen Verschieben der Maske so gesteuert werden, daß nacheinander verschiedene auf der Maske befindliche Kontrollstrukturen und/oder fertigungskritische Maskenstrukturen überprüfbar sind. Es kann beispielsweise eine Sequenz von besonders kritischen Bereichen festgelegt werden, die nacheinander angefahren und überprüft werden sollen. Darüber hinaus können an bestimmten Stellen der Maske komplizierte Kontrollstrukturen aufgebracht sein, deren Überprüfung eine Aussage über die Qualität der Maske ermöglicht.

Nachfolgend wird die Erfindung anhand mehrerer in der Zeichnung dargestellter Ausführungsbeispiele weiter beschrieben. Es zeigen:
- Fig. 1: eine Photomaske in Draufsicht;
- Fig. 2A: eine Chrom- oder MoSi-Maske im Längsschnitt;
- Fig. 2B: eine Tritone-Maske im Längsschnitt;
- Fig. 2C: eine chromlose Phasenmaske im Längsschnitt;
- Fig. 3: eine schematische Darstellung eines Rasterkraftmikroskops;
- Fig. 4: eine schematische Darstellung eines Oberflächenprofilometers;
- Fig. 5: eine Darstellung der erfindungsgemäßen Vorrichtung zum Abbilden und Abtasten von Photomasken;
- Fig. 6: einen Beleuchtungsstrahlengang, bei dem die Lichtquelle auf der Seite des optischen Mikroskops angeordnet ist (Auflichtgeometrie);
- Fig. 7: einen Beleuchtungsstrahlengang, bei dem die Lichtquelle auf der Seite des abtastenden Instruments angebracht ist (Durchlichtgeometrie).

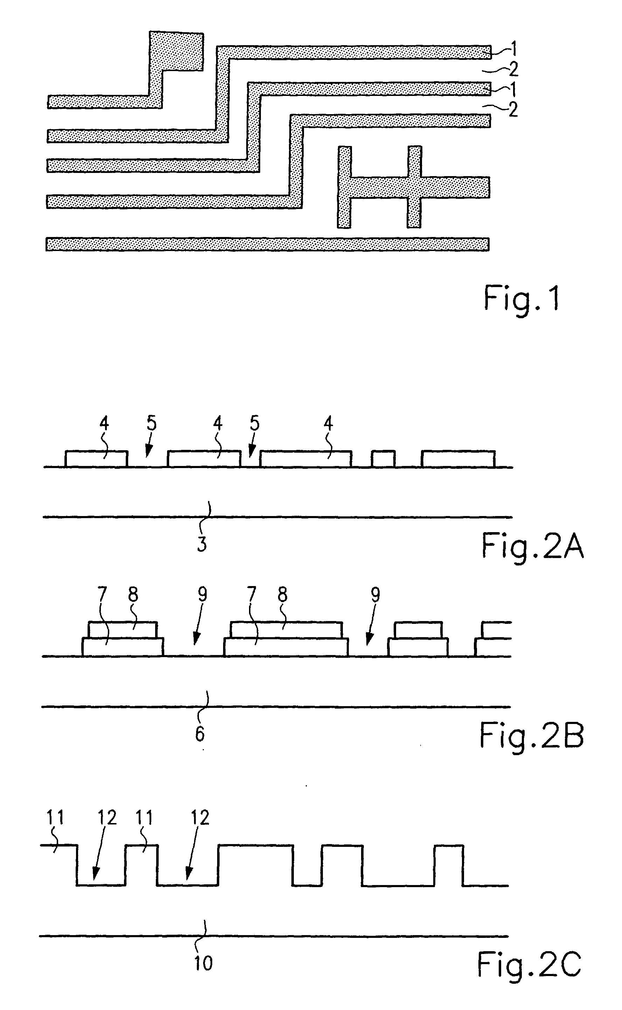

Figur 1 zeigt einen Ausschnitt einer Photomaske in Draufsicht. In den lichtundurchlässigen Bereichen 1 ist das Glassubstrat mit einer aufgedampften Materialschicht versehen, in den lichtdurchlässigen Bereichen 2 dagegen nicht.

In den Fig. 2A bis 2C sind verschiedene Typen von Photomasken im Längsschnitt dargestellt. In Fig. 2A ist ein Glassubstrat 3 mit aufgedampften Strukturen 4 beschichtet worden. Die Dikke des Glassubstrats 3 liegt zwischen 2,5 mm und 6,3 mm; die Dicke der aufgedampften Strukturen 4 beträgt typischerweise 100 nm. Als Aufdampfmaterialien eignen sich Chrom (Cr) sowie Molybdänsilizium (MoSi). Die aufgedampften Strukturen 4 sind weitgehend lichtundurchlässig, während die unbedampften Bereiche 5 lichtdurchlässig sind. Die typische Strukturgröße (main feature size) der aktuell in der Halbleiterfertigung verwendeten Masken beträgt ca. 700 nm. Masken mit MoSi-Bedampfung werden auch als "Halftone"-Masken bezeichnet, weil eine MoSi-Bedampfung eine etwas höhere Transmission aufweist als eine Cr-Bedampfung.

In Fig. 2B ist ein Längsschnitt durch eine Tritone-Maske dargestellt. Die Tritone-Maske besteht aus einem Glassubstrat 6, auf das eine strukturierte MoSi-Aufdampfschicht 7 von ca. 100 nm Dicke aufgebracht wurde. Auf die von MoSi belegten Bereich wurde zusätzlich eine Cr-Aufdampfschicht 8 von ebenfalls ca. 100 nm Dicke so aufgebracht, daß die MoSi-Aufdampfschicht 7 gegenüber der Cr-Aufdampfschicht 8 etwas vorsteht. In diesen Randbereichen ist die Tritone-Maske geringfügig lichtdurchlässig, während sie in den von der Cr-Aufdampfschicht 8 abgedeckten Bereichen vollkommen lichtundurchlässig ist. Die unbedampften Bereiche 9 sind lichtdurchlässig.

In Fig. 2C ist eine (chromlose) Phasenmaske 10 im Längsschnitt dargestellt, welche eine Struktur aus Bereichen hoher optischer Weglänge 11 und Bereichen niedriger optischer Weglänge 12 aufweist. Eine derartige Phasenmaske wird durch selektives Ätzen eines Glassubstrats hergestellt, wobei typische Ätztiefen bei 240 nm bis 700 nm liegen. Die "main feature size" einer Phasenmaske liegt ebenfalls bei ca. 700 nm.

Während die in Fig. 2A und 2B dargestellten Maskenstrukturen mit konventionellen Mikroskopiemethoden sichtbar gemacht werden können, sind die Strukturen der in Fig. 2C dargestellten Phasenmaske nur mit Mikroskopiemethoden erkennbar, welche Phasenunterschiede in Helligkeitsunterschiede umwandeln (z.B. Phasenkontrastmikroskopie, Schlierenverfahren etc.).

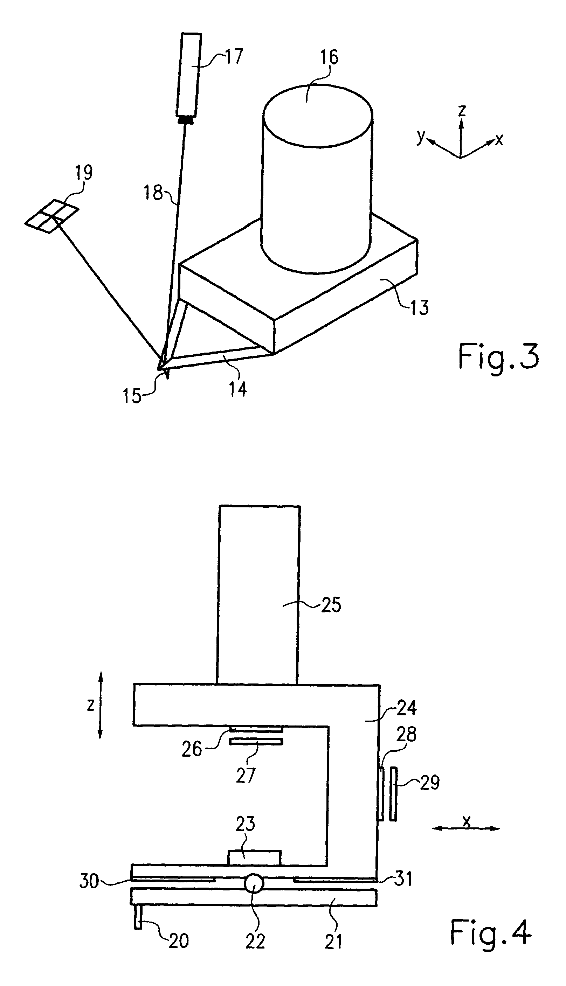

Zur Qualitätskontrolle von Photomasken werden neben abbildenden Mikroskopieverfahren auch abtastende Verfahren eingesetzt. Ein Beispiel für eine derartige Technik ist die Rasterkraftmikroskopie, deren Funktionsprinzip anhand von Fig. 3 erläutert werden soll. Am Meßkopf 13 ist ein in z-Richtung auslenkbarer Cantilever 14 angebracht, der an seinem vorderen Ende eine Abtastspitze 15 aufweist. Mit dem piezokeramischen Stellelement 16 kann der Meßkopf 13 sowohl lateral (also in x- und y-Richtung) als auch in z-Richtung positioniert werden. Mit piezokeramischen Stellelementen ist eine Positoniergenauigkeit im Nanometer-Bereich realisierbar. Die Auslenkung des Cantilevers 14 wird mit Hilfe eines Lichtzeigers detektiert. Dazu erzeugt die Laserdiode 17 einen Laserstrahl 18, der von der Oberseite des Cantilevers 14 in Richtung der Multisegment-Photodiode 19 reflektiert wird. Aus den Photospannungen, die an den einzelnen Segmenten der Multisegment-Photodiode 19 anliegen, kann die Auslenkung des Cantilevers 14 bestimmt werden.

Zur Abtastung des Höhenprofils einer Photomaske wird das Rasterkraftmikroskop im Scan-Modus betrieben. Dazu wird zunächst eine bestimmte x-, y-Position des Meßkopfs 13 durch das piezokeramische Stellelement 16 vorgegeben. Anschließend erfolgt ein konstanter Vorschub des Meßkopfs 13 in Richtung der Photomaske (also in z-Richtung). Dieser Vorschub wird erzeugt, indem an das piezokeramische Stellelement 16 eine Spannungsrampe angelegt wird. Sobald die Abtastspitze 15 auf die Maskenoberfläche auftrifft, beginnt sich der Cantilever 14 zu verbiegen, und diese Auslegung kann über die Multisegment-Photodiode 19 erfaßt werden. Die z-Position des piezokeramischen Stellelements 16 zum Zeitpunkt des Beginns der Cantileverauslenkung wird gespeichert. Derartige z-Werte werden für verschiedene x-, y-Positionen des Meßkopfs 13 erfaßt. Diese z-Werte geben direkt das Höhenprofil der Photomaske wieder.

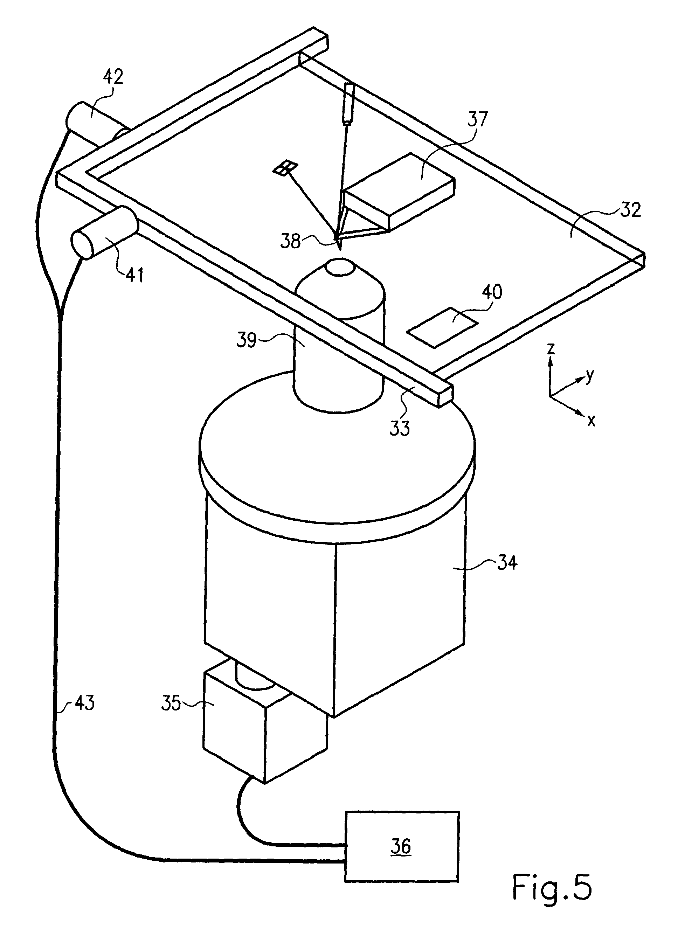

In Fig. 4 ist der prinzipielle Aufbau eines Oberflächenprofilometers dargestellt. Derartige Instrumente werden sowohl zur Oberflächenanalyse von Halbleiterstrukturen als auch von Photomasken eingesetzt. Die Abtastung erfolgt mittels der Abtastsonde 20, wobei als Abtastsonde typischerweise ein Glasröhrchen von ca. 200 nm Durchmesser verwendet wird. Die Abtastsonde 20 ist an einer Abtastwippe 21 befestigt, die ihrerseits mit der Stahlkugel 22 verbunden ist. Durch die Magnetkraft des Magneten 23 werden sowohl die Stahlkugel 22 als auch die damit verbundene Wippe 21 am Meßkopf 24 gelenkig fixiert. Der Meßkopf, die damit verbundene Wippe und die Abtastsonde können durch das piezokeramische Stellelement 25 in x-, y- und z-Richtung frei positioniert werden. Dabei erfassen kapazitive Meßaufnehmer die aktuelle Position des Meßkopfs. Zu diesem Zweck ist eine erste Kondensatorplatte 26 fest mit dem Meßkopf 24 verbunden und bildet mit der ortsfest aufgehängten Kondensatorplatte 27 eine Kapazität. Wenn sich die z-Position des Meßkopfs 24 verändert, verändert sich damit auch der Abstand zwischen den beiden Kondensatorplatten 26 und 27. Durch eine Messung der Kapazität zwischen den Platten 26 und 27 läßt sich daher die z-Position des Meßkopfs 24 erfassen. Entsprechend umfaßt der Meßaufnehmer für die x-Position eine mit dem Meßkopf 24 verbundene Kondensatorplatte 28 sowie eine ortsfeste Kondensatorplatte 29.

Zur Aufzeichnung des Oberflächenprofils einer Probe wird der Meßkopf 24 in z-Richtung auf die Probe zu bewegt. Sobald die Abtastsonde 20 auf der Probenoberfläche auftrifft, wird die Abtastwippe 21 ausgelenkt. Um diese Auslenkung erfassen zu können, sind zwei Kondensatorplatten 30 und 31 am Meßkopf 24 angebracht, die jeweils zusammen mit der Abtastwippe 21 eine Kapazität bilden. Wenn die Abtastwippe 21 ausgelenkt wird, dann verkleinert sich der Abstand zwischen der Platte 30 und der Wippe 21, während sich der Abstand zwischen der Platte 31 und der Wippe 21 erhöht. Durch Messung dieser Kapazität bzw. der Differenz dieser Kapazitäten läßt sich der Punkt des Auftreffens der Abtastsonde 20 auf der Probe erfassen. Die zu diesem Auftreffzeitpunkt gehörige z-Position wird gespeichert. Anschließend wird der Meßkopf in z-Richtung von der Probe wegbewegt und lateral neu positioniert. Dann wird der Meßkopf wieder in z-Richtung auf die Probe zu bewegt, um die z-Position des Auftreffpunkts an dieser Stelle zu ermitteln. Durch dieses "nähmaschinenartige" Abtasten der Probenoberfläche kann das Oberflächenprofil aufgezeichnet werden.

Anhand von Fig. 5 soll das erfindungsgemäße Positionierprinzip dargestellt werden. Die fertige Photomaske 32 wird dazu auf eine bestimmte Stelle Maskentischs 33 gelegt, der ein Verschieben der Maske in x- und y-Richtung erlaubt. Das invertierte Mikroskop 34 bildet einen bestimmten Ausschnitt der Photomaske 32 optisch ab. Die Bildauswertung kann dabei entweder von einem Betrachter über ein Okular vorgenommen werden, die Auswertung kann aber auch über eine Kamera 35 und eine Bildverarbeitungseinheit 36 erfolgen. In der Bildverarbeitungseinheit 36 können die aufgezeichneten Maskenstrukturen mit gespeicherten Maskenstrukturen verglichen werden, um so die Qualität der Photomaske beurteilen zu können.

In einem ersten Schritt müssen das abtastende Instrument (in Fig. 5 ist ein Rasterkraftmikroskop 37 gezeigt) und das optische Mikroskop 34 relativ zueinander so positioniert werden, daß die Abtastspitze 38 des Rasterkraftmikroskops 37 im Gesichtsfeld des optischen Mikroskops 34 erkennbar ist. Dies ist dann der Fall, wenn sich das Objektiv 39 des optischen Mikroskops 34 und die Abtastspitze 38 in einander gegenüberliegenden Positionen befinden. In dieser sogenannten "On-Axis" Position kann die Bewegung der Abtastspitze 38 unter Sicht verfolgt werden. Um die Instrumente anfangs in dieser Position zu justieren, ist entweder das invertierte optische Mikroskop 34 oder das Rasterkraftmikroskop 37 in x-, y-Richtung verschieblich gelagert. Die Einstellung der "On-Axis" Position erfolgt dann mittels Gewindestangen, Stellschrauben oder anderer Positionierelemente. In der "On-Axis" Position werden die beiden Instrumente relativ zueinander fixiert.

Die Einstellung des abzutastenden und abzubildenden Maskenausschnitts kann dann ausschließlich durch Verschieben des Maskentischs 33 erfolgen. Wenn eine neue Stelle auf der Photomaske 32 angefahren wird, beispielsweise die Kontrollstruktur 40, so sind auch in der neuen Position des Maskentischs 33 die Abtastspitze 38 und das Objektiv 39 in der "On-Axis" Position, so daß die Abtastspitze 38 ohne Neujustierung im Mikroskopbild sichtbar ist. Daher kann die Abtastspitze 38 unter Sicht an der neuen Stelle richtig positioniert werden.

Zur hochgenauen Positionierung des Maskentischs 33 sind Schrittmotoren 41 (für die x-Richtung) und 42 (für die y-Richtung) vorgesehen. Die Auswahl der anzufahrenden Maskenposition kann entweder manuell oder durch ein Steuerprogramm vorgenommen werden. Auf diese Weise ist es möglich, eine ganze Sequenz von fertigungskritischen Maskenstrukturen oder von Kontrollstrukturen 40 nacheinander anzufahren und zu überprüfen. Die Steuersignale zur Ansteuerung der Schrittmotoren 41 und 42 können aber auch von der Bildverarbeitungseinheit 36 geliefert werden, welche aus dem aktuellen Mikroskopbild durch Vergleich mit gespeicherten Maskenstrukturen die Ist-Position ermittelt und aus der Abweichung zwischen Ist-Position und Soll-Position die notwendigen Steuersignale generiert, die über die Signalleitungen 43 zu den Schrittmotoren 41 und 42 übertragen werden.

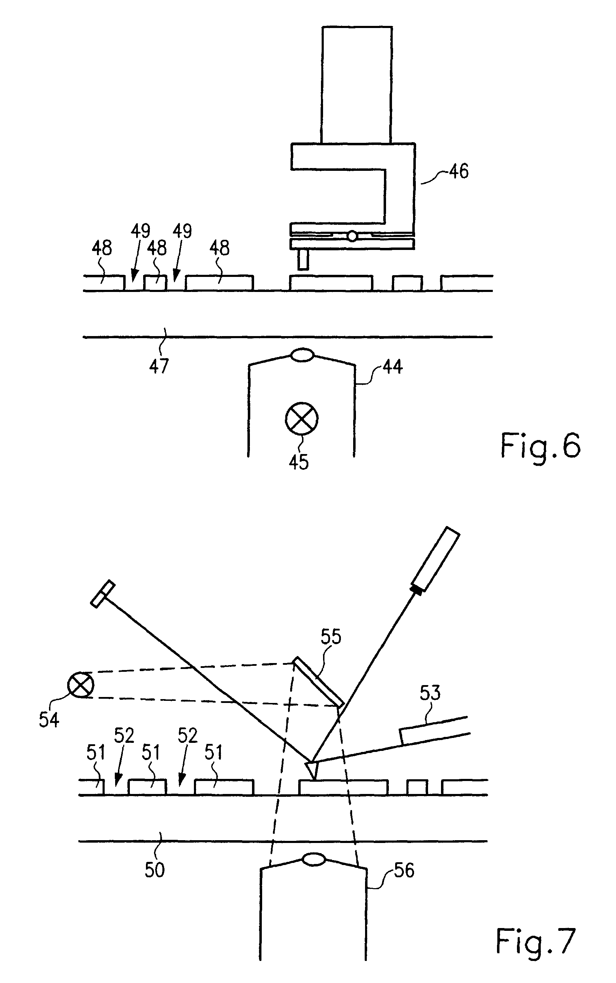

Die Beleuchtung der Maske kann entweder von der Seite des abtastenden Instruments her, oder aber von der Seite des optischen Mikroskops her erfolgen. Fig. 6 zeigt einen Beleuchtungsstrahlengang, bei dem die Photomaske 47 von der Seite des optischen Mikroskops 44, und nicht von der Seite des abtastenden Instruments 46 her beleuchtet wird. Zu diesem Zweck ist die Lichtquelle 45 so in das optische Mikroskop 44 integriert, daß ihr Licht durch das Objektiv hindurch auf die Photomaske 47 fällt. Von den aufgedampften Strukturen 48 wird das Beleuchtungslicht zum optischen Mikroskop 44 hin zurückreflektiert, während in den unbedampften Bereichen 49 keine Reflexion stattfindet. Die aufgedampften Strukturen 48 erscheinen daher im Mikroskopbild als helle Bereiche, während die unbedampften Bereiche 49 dunkel erscheinen. Wenn sich die Sonde des abtastenden Instruments 46 in einem unbedampften Bereich 49 befindet, so gelangt Beleuchtungslicht durch die Photomaske 47 hindurch zur Sonde, die sich dann hell gegen den dunklen Hintergrund abhebt.

Diese Beleuchtungsgeometrie ist unabhängig von dem erfindungsgemäßen Positionierverfahren immer dann von Vorteil, wenn eine Maske abgetastet und abgebildet werden soll. Man macht sich zunutze, daß die aufgedampften Strukturen das Beleuchtungslicht gut reflektieren, während die unbedampften Bereiche das Beleuchtungslicht nicht reflektieren. Dadurch kann eine kontrastreiche Abbildung erhalten werden. Der Vorteil dieser Anordnung ist, daß die Lichtquelle das abtastende Instrument nicht behindert. Ein weiterer Vorteil ist, daß die Lichtquelle in das optische Mikroskop integriert werden kann.

In Fig. 7 ist eine alternative Beleuchtungsanordnung dargestellt, bei der die Beleuchtung durch die Photomaske 50 hindurch erfolgt (Durchlichtgeometrie). Die Oberfläche der Photomaske 50 weist Bereiche mit aufgedampften Strukturen 51 sowie unbedampfte Bereiche 52 auf. Durch das invertierte Mikroskop 56 werden diese Strukturen von der Unterseite her abgebildet. Von der Schichtseite her werden sie durch das Rasterkraftmikroskop 53 abgetastet. Die Lichtquelle 54 ist auf der Seite des Rasterkraftmikroskops 53 angeordnet und beleuchtet die Maske 50 über den Spiegel 55. Die aufgedampften Strukturen 51 sind lichtundurchlässig und erscheinen deswegen im Mikroskopbild als dunkle Bereiche. In den unbedampften Bereichen 52 dagegen kann das Licht der Beleuchtungsquelle 54 ungehindert durch die Photomaske 50 hindurch zum invertierten Mikroskop 56 gelangen. Die unbedampften Bereiche 52 erscheinen daher als helle Bereiche.

## Patentansprüche

1. Vorrichtung zum Abbilden und Abtasten von Masken für die Halbleiterfertigung, welche aufweist
- ein abtastendes Instrument (37) zur Abtastung der Schichtseite der Maske (32) mittels einer Sonde (38),
- ein optisches Mikroskop (34) zur Abbildung eines Ausschnitts der Maske (32) von der der Schichtseite abgewandten Maskenseite her,
**gekennzeichnet durch**
- Mittel zur Positionierung des abtastenden Instruments (37) und des gegenüberliegenden optischen Mikroskops (34) relativ zueinander dergestalt, daß die Sonde (38) des abtastenden Instruments (37) von dem optischen Mikroskop (34) mit abgebildet werden kann, sowie
- Mittel zum lateralen Verschieben der Maske, **durch** die der abgebildete Ausschnitt der Maske unter Beibehaltung der Relativposition zwischen dem abtastenden Instrument (37) und dem gegenüberliegenden optischen Mikroskop (34) auswählbar ist.

2. Vorrichtung nach Anspruch 1,
**dadurch gekennzeichnet, daß**
die Mittel zum lateralen Verschieben der Maske einen verschieblich gelagerten Maskentisch (33) umfassen.

3. Vorrichtung nach Anspruch 2,
**dadurch gekennzeichnet, daß**
der Maskentisch (33) mittels Schrittmotoren (41, 42) positionierbar ist.

4. Vorrichtung nach einem der vorhergehenden Ansprüche,
**dadurch gekennzeichnet, daß**
die Mittel zur Positionierung des abtastenden Instruments (37) und des gegenüberliegenden optischen Mikroskops (34) relativ zueinander mittels einer verschieblichen Lagerung des abtastenden Instruments (37) und/oder des optischen Mikroskops (34) realisiert sind.

5. Vorrichtung nach einem der vorhergehenden Ansprüche,
**dadurch gekennzeichnet, daß**
es sich bei dem abtastenden Instrument (37) um ein Rastersondenmikroskop handelt.

6. Vorrichtung nach Anspruch 5,
**dadurch gekennzeichnet, daß**
es sich bei dem abtastenden Instrument (37) um ein Rasterkraftmikroskop handelt.

7. Vorrichtung nach Anspruch 5,
**dadurch gekennzeichnet, daß**
es sich bei dem abtastenden Instrument (37) um ein Rasterelektronenmikroskop handelt.

8. Vorrichtung nach einem der Ansprüche 1 bis 4,
**dadurch gekennzeichnet, daß**
es sich bei dem abtastenden Instrument (37) um ein Oberflächenprofilometer handelt.

9. Vorrichtung nach einem der vorhergehenden Ansprüche,
**dadurch gekennzeichnet, daß**
die für die optische Abbildung erforderliche Beleuchtung (45) der Maske (47) von der der Schichtseite abgewandten Maskenseite her erfolgt.

10. Vorrichtung nach einem der Ansprüche 1 bis 8,
**dadurch gekennzeichnet, daß**
die für die optische Abbildung erforderliche Beleuchtung (54) der Maske (50) von der Schichtseite der Maske (50) her erfolgt.

11. Vorrichtung nach Anspruch 10,
**dadurch gekennzeichnet, daß**
der Beleuchtungsstrahlengang mindestens einen Spiegel (55) umfaßt.

12. Vorrichtung nach einem der vorhergehenden Ansprüche,
**dadurch gekennzeichnet, daß**
das optische Mikroskop (34) ein Long Working Distance (LWD) Objektiv aufweist.

13. Vorrichtung nach einem der vorhergehenden Ansprüche,
**dadurch gekennzeichnet, daß**
das optische Mikroskop (34) ein Phasenkontrastmikroskop ist und daß als Maske eine Phasenmaske verwendet wird.

14. Vorrichtung nach einem der vorhergehenden Ansprüche,
**dadurch gekennzeichnet, daß**
das optische Mikroskop (34) mit einer Kamera (35) verbunden ist, welche Daten an eine Bildverarbeitungseinheit (36) liefert.

15. Vorrichtung nach Anspruch 14,
**dadurch gekennzeichnet, daß**
in der Bildverarbeitungseinheit (36) ein Vergleich des abgebildeten Ausschnitts der Maske mit gespeicherten Maskendaten durchgeführt wird.

16. Vorrichtung nach Anspruch 14 oder Anspruch 15,
**dadurch gekennzeichnet, daß**
die Bildverarbeitungseinheit Steuersignale zur Positionierung der Maske (32) erzeugt, welche die Mittel (33) zum lateralen Verschieben der Maske steuern.

17. Vorrichtung nach einem der vorhergehenden Ansprüche,
**dadurch gekennzeichnet, daß**
die Mittel zum lateralen Verschieben der Maske so gesteuert werden, daß auf der Maske (32) befindliche Kontrollstrukturen (40) und/oder fertigungskritische Maskenstrukturen überprüfbar sind.

18. Verfahren zum Abbilden und Abtasten von Masken für die Halbleiterfertigung mittels einer Vorrichtung, die
- ein abtastendes Instrument (37) zur Abtastung der Schichtseite der Maske mittels einer Sonde (38), sowie
- ein optisches Mikroskop (34) zur Abbildung eines Ausschnitts der Maske von der der Schichtseite abgewandten Maskenseite her umfaßt,
**gekennzeichnet durch** folgende Schritte:
a) Positionieren des abtastenden Instruments (37) und des optischen Mikroskops (34) relativ zueinander dergestalt, daß die Sonde (38) des abtastenden Instruments (37) von dem optischen Mikroskop (34) mit abgebildet werden kann;
b) laterales Verschieben der Maske (32) unter Beibehaltung der Relativposition zwischen dem abtastenden Instrument (37) und dem gegenüberliegenden optischen Mikroskop (34);
c) Abbilden und/oder Abtasten des ausgewählten Ausschnitts der Maske.

19. Verfahren nach Anspruch 18,
**dadurch gekennzeichnet, daß**
das laterale Verschieben der Maske mittels eines verschieblich gelagerten Maskentischs (33) erfolgt.

20. Verfahren nach Anspruch 19,
**dadurch gekennzeichnet, daß**
der Maskentisch (33) mittels Schrittmotoren (41, 42) positioniert wird.

21. Verfahren nach einem der Ansprüche 18 bis 20,
**dadurch gekennzeichnet, daß**
das Positionieren des abtastenden Instruments (37) und des optischen Mikroskops (34) relativ zueinander mittels einer verschieblichen Lagerung des abtastenden Instruments (37) und/oder des optischen Mikroskops (34) erfolgt.

22. Verfahren nach einem der Ansprüche 18 bis 21,
**dadurch gekennzeichnet, daß**
die Maske (47) von der der Schichtseite abgewandten Maskenseite her beleuchtet wird.

23. Verfahren nach einem der Ansprüche 18 bis 21,
**dadurch gekennzeichnet, daß**
die Maske (50) von der Schichtseite her beleuchtet wird.

24. Verfahren nach Anspruch 23,
**dadurch gekennzeichnet, daß**
der Beleuchtungsstrahlengang einen Spiegel (55) umfaßt.

25. Verfahren nach einem der Ansprüche 18 bis 24,
**dadurch gekennzeichnet, daß**
das laterale Verschieben der Maske (32) so gesteuert wird, daß auf der Maske befindliche Kontrollstrukturen (40) und/oder fertigungskritische Maskenstrukturen überprüft werden.

## Claims

1. Apparatus for imaging and scanning masks for semiconductor production, which has
- a scanning instrument (37) for scanning the layer side of the mask (32) by means of a probe (38),
- an optical microscope (34) for imaging a detail of the mask (32) from the side of the mask facing away from the layer side,
**characterized by**
- means for positioning the scanning instrument (37) and the opposing optical microscope (34) relative to each other such that the probe (38) of the scanning instrument (37) can be imaged by the optical microscope (34) at the same time, and
- means for the lateral displacement of the mask, by means of which the imaged detail of the mask can be selected while maintaining the relative position between the scanning instrument (37) and the opposing optical microscope (34).

2. Apparatus according to Claim 1, **characterized in that** the means for the lateral displacement of the mask comprise a displaceably mounted mask table (33).

3. Apparatus according to Claim 2, **characterized in that** the mask table (33) can be positioned by means of stepping motors (41, 42).

4. Apparatus according to one of the preceding claims, **characterized in that** the means for positioning the scanning instrument (37) and the opposing optical microscope (34) relative to each other are implemented by means of a displaceable mounting of the scanning instrument (37) and/or of the optical microscope (34).

5. Apparatus according to one of the preceding claims, **characterized in that** the scanning instrument (37) is a scanning probe microscope.

6. Apparatus according to Claim 5, **characterized in that** the scanning instrument (37) is a scanning force microscope.

7. Apparatus according to Claim 5, **characterized in that** the scanning instrument (37) is a scanning electron microscope.

8. Apparatus according to one of Claims 1 to 4, **characterized in that** the scanning instrument (37) is a surface profilometer.

9. Apparatus according to one of the preceding claims, **characterized in that** the illumination (45) needed for the optical imaging of the mask (47) is carried out from the side of the mask facing away from the layer side.

10. Apparatus according to one of Claims 1 to 8, **characterized in that** the illumination (54) needed for the optical imaging of the mask (50) is carried out from the layer side of the mask (50).

11. Apparatus according to Claim 10, **characterized in that** the illumination beam path comprises at least one mirror (55).

12. Apparatus according to one of the preceding claims, **characterized in that** the optical microscope (34) has a long working distance (LWD) objective.

13. Apparatus according to one of the preceding claims, **characterized in that** the optical microscope (34) is a phase contrast microscope and the mask used is a phase mask.

14. Apparatus according to one of the preceding claims, **characterized in that** the optical microscope (34) is connected to a camera (35), which supplies data to an image processing unit (36).

15. Apparatus according to Claim 14, **characterized in that** in the image processing unit (36), a comparison is made between the imaged detail of the mask and stored mask data.

16. Apparatus according to Claim 14 or Claim 15, **characterized in that** the image processing unit generates control signals for positioning the mask (32), which control the means (33) for lateral displacement of the mask.

17. Apparatus according to one of the preceding claims, **characterized in that** the means for lateral displacement of the mask are controlled in such a way that control structures (40) and/or critical production mask structures located on the mask (32) can be checked.

18. Method of imaging and scanning masks for semiconductor production by means of an apparatus which comprises
- a scanning instrument (37) for scanning the layer side of the mask by means of a probe (38), and
- an optical microscope (34) for imaging a detail of the mask from the side of the mask facing away from the layer side,
**characterized by** the following steps:
a) positioning the scanning instrument (37) and the optical microscope (34) relative to each other such that the probe (38) of the scanning instrument (37) can be imaged by the optical microscope (34) at the same time;
b) displacing the mask (32) laterally while maintaining the relative position between the scanning instrument (37) and the opposing optical microscope (34);
c) imaging and/or scanning the selected detail of the mask.

19. Method according to Claim 18, **characterized in that** the lateral displacement of the mask is carried out by means of a displaceably mounted mask table (33).

20. Method according to Claim 19, **characterized in that** the mask table (33) is positioned by means of stepping motors (41, 42).

21. Method according to one of Claims 18 to 20, **characterized in that** the positioning of the scanning instrument (37) and of the optical microscope (34) relative to each other is carried out by means of a displaceable mounting of the scanning instrument (37) and/or of the optical microscope (34).

22. Method according to one of Claims 18 to 21, **characterized in that** the mask (47) is illuminated from the side of the mask facing away from the layer side.

23. Method according to one of Claims 18 to 21, **characterized in that** the mask (50) is illuminated from the layer side.

24. Method according to Claim 23, **characterized in that** the illumination beam path comprises a mirror (55).

25. Method according to one of Claims 18 to 24, **characterized in that** the lateral displacement of the mask (32) is controlled in such a way that control structures (40) and/or critical production mask structures located on the mask are checked.

## Revendications

1. Dispositif de reproduction et de balayage de masques pour la fabrication de semiconducteur, qui comprend
- un instrument (37) de balayage pour balayer le côté de couche du masque (32) au moyen d'une sonde (38),
- un microscope (34) optique pour reproduire une partie du masque (32) à partir du côté du masque opposé au côté de couche,
**caractérisé par**
- des moyens de mise en position de l'instrument (37) de balayage et du microscope (34) optique opposés l'un par rapport à l'autre de façon à ce que la sonde (38) de l'instrument (37) de balayage puissent être reproduite par le microscope (34) optique, ainsi que
- des moyens de déplacement latéral du masque, par lesquels la partie reproduite du masque peut être sélectionnée tout en conservant la position relative entre l'instrument (37) de balayage et le microscope (34) optique opposé.

2. Dispositif suivant la revendication 1,
**caractérisé en ce que** les moyens de déplacement latéral du masque comprennent une table (33) de masque montée coulissante.

3. Dispositif suivant la revendication 2,
**caractérisé en ce que** la table (33) de masque peut être mise en position au moyen de moteurs (41, 42) pas à pas.

4. Dispositif suivant l'une des revendications précédentes, **caractérisé en ce que** les moyens de mise en position de l'instrument (37) de balayage et du microscope (34) optique opposé l'un par rapport à l'autre sont réalisés au moyen d'un montage coulissant de l'instrument (37) de balayage et/ou du microscope (34) optique.

5. Dispositif suivant l'une des revendications précédentes, **caractérisé en ce que** l'instrument (37) de balayage est un microscope à centre de balayage.

6. Dispositif suivant la revendication 5,
**caractérisé en ce que** l'instrument (37) de balayage est un microscope à balayage à application d'une force.

7. Dispositif suivant la revendication 5,
**caractérisé en ce que** l'instrument (37) de balayage est un microscope électronique à balayage.

8. Dispositif suivant l'une des revendications 1 à 4,
**caractérisé en ce que** l'instrument (37) de balayage est un profilomètre de surface.

9. Dispositif suivant l'une des revendications précédentes, **caractérisé en ce que** l'éclairage (45) du masque (47) nécessaire pour la reproduction optique s'effectue par le côté du masque éloigné du côté de couche.

10. Dispositif suivant l'une des revendications 1 à 8, **caractérisé en ce que** l'éclairage (54) du masque (50) nécessaire pour la reproduction optique s'effectue par le côté de couche du masque (50).

11. Dispositif suivant la revendication 10,
**caractérisé en ce que** le trajet du rayonnement d'éclairage comprend au moins un miroir (55).

12. Dispositif suivant l'une des revendications précédentes,
**caractérisé en ce que** le microscope (34) optique a un objectif à grande distance focale (LWD).

13. Dispositif suivant l'une des revendications précédentes,
**caractérisé en ce que** le microscope (34) optique est un microscope à contraste de phase, et il est utilisé comme masque un masque de phase.

14. Dispositif suivant l'une des revendications précédentes,
**caractérisé en ce que** le microscope (34) optique est relié à une caméra (35) qui fournie des données sur une unité (36) de traitement de l'image.

15. Dispositif suivant la revendication 14,
**caractérisé en ce que** dans l'unité (36) de traitement de l'image est effectuée une comparaison de la partie du masque qui est reproduite à des données de masque qui sont mémorisées.

16. Dispositif suivant la revendication 14 ou 15,
**caractérisé en ce que** l'unité de traitement d'image produit des signaux de commande pour la mise en position du masque (32) qui commandent les moyens (33) de déplacement latéral du masque.

17. Dispositif suivant l'une des revendications précédentes,
**caractérisé en ce que** les moyens de déplacement latéral du masque sont commandés de manière à pouvoir contrôler des structures (40) de contrôle et/ou des structures de masque critiques du point de vue de la fabrication qui se trouvent sur le masque (32).

18. Procédé de reproduction et de balayage de masque pour la fabrication de semiconducteur au moyen d'un dispositif, qui comprend
- un instrument (37) de balayage pour balayer le côté de couche du masque au moyen d'une sonde (38), ainsi que
- un microscope (34) optique pour reproduire une partie du masque à partir du côté du masque opposé au côté de couche,
**caractérisé par** les stades suivants :
a) on met l'instrument (37) de balayage et le microscope (34) optique opposé en position l'un par rapport à l'autre de façon à ce que la sonde (38) de l'instrument (37) de balayage puisse être reproduite par le microscope (34) optique;
b) on déplace latéralement le masque (32) tout en conservant la position relative entre l'instrument (37) de balayage et le microscope (34) optique opposé;
c) on reproduit et/ou on balaye la partie sélectionnée du masque.

19. Procédé suivant la revendication 18,
**caractérisé en ce que** l'on effectue le déplacement latéral du masque au moyen d'une table (33) de masque montée coulissante.

20. Procédé suivant la revendication 19,
**caractérisé en ce que** l'on met la table (33) de masque en position au moyen de moteurs (41, 42) pas à pas.

21. Procédé suivant l'une des revendications 18 à 20,
**caractérisé en ce que** l'on effectue la mise en position de l'instrument (37) de balayage et du microscope (34) optique l'un par rapport à l'autre au moyen d'un montage coulissant de l'instrument (37) de balayage et/ou du microscope (34) optique.

22. Procédé suivant l'une des revendications 18 à 21,
**caractérisé en ce que** l'on éclaire le masque (47) par le côté du masque éloigné du côté de couche.

23. Procédé suivant l'une des revendications 18 à 23,
**caractérisé en ce que** l'on éclaire le masque (50) par le côté de couche.

24. Procédé suivant la revendication 23,
**caractérisé en ce que** le trajet de rayonnement d'éclairage comprend un miroir (55).

25. Procédé suivant l'une des revendications 18 à 24,
**caractérisé en ce que** l'on commande le déplacement latéral du masque (32) de façon à contrôler des structures (40) de contrôle et/ou des structures de masque critiques du point de vue de la fabrication qui se trouvent sur le masque.
